# EUROPÄISCHE PATENTSCHRIFT

(11) **EP 1 310 003 B1**
(45) Veröffentlichungstag und Bekanntmachung des Hinweises auf die Patenterteilung: **08.02.2012**
(21) Anmeldenummer: 01960153.3
(22) Anmeldetag: 06.08.2001
(51) Int. Cl.: H01L 41/053, F16K 31/00, F02M 51/06, F02M 61/16

(54) **GERÄUSCHGEDÄMPFTE AKTOREINHEIT**
SILENCED ACTUATOR UNIT
UNITE ACTIONNEUR INSONORISEE

(30) Priorität: 17.08.2000 DE 10040239
(43) Veröffentlichungstag der Anmeldung: 14.05.2003
(73) Patentinhaber: Continental Automotive GmbH, 30165 Hannover (DE)
(72) Erfinder: SCHÜRZ, Willibald, 93188 Pielenhofen (DE)
(86) Internationale Anmeldenummer: PCT/DE2001/002995
(87) Internationale Veröffentlichungsnummer: WO 2002/015291

(56) Entgegenhaltungen:
- EP-A- 0 869 278
- DE-A- 19 727 992
- DE-A- 19 826 341

## Beschreibung

Die Erfindung betrifft eine geräuschgedämpfte Aktoreinheit gemäß dem Oberbegriff des Patentanspruchs 1. Eine solche Aktoreinheit mit piezoelektrisch wirkendem Aktorelement ist beispielsweise aus der DE 3844134 C2 bekannt.

DE 19727992 A1 offenbart ein Ausgleichselement zur Kompensation temperaturbedingter Längenänderungen, beispielsweise eines piezoelektrischen Aktors. Eine ölgefüllte Kammer des Ausgleichselements besteht aus einem aktorseitigen oberen Teil, einem sich an einem Ventilgehäuse abstützenden unteren Teil und einem die Kammer abdichtenden, in axialer Richtung nachgiebigem ringförmigen Dichtelement. Eine temperaturbedingte Änderung des Öl- bzw. Kammervolumens verursacht eine der Volumenänderung proportionale Verschiebung in axialer Richtung des oberen Teils.

Bei der Kraftstoffversorgung von Brennkraftmaschinen werden zunehmend Speichereinspritzsysteme eingesetzt, bei denen mit sehr hohen Einspritzdrücken und schnellen Schaltgeschwindigkeiten der Zumesseinrichtungen, der sogenannten Injektoren gearbeitet wird. Bei derartigen Speichereinspritzsystemen wird Kraftstoff mit Hilfe von Kraftstoffinjektoren in die Brennräume der Brennkraftmaschine eingespritzt. Der Kraftstoffinjektor weist im Allgemeinen eine Einspritzdüse auf, die hydraulisch von einem Servoventil geöffnet und geschlossen wird, um den zeitlichen Verlauf des Einspritzvorganges in die Brennkammer exakt festzulegen. Das Servoventil wird dabei von einem elektrisch angesteuerten Aktor betätigt, wobei sich vor allem der Einsatz von piezoelektrischen Aktoren zum Erzielen ausreichend kurzer Schaltzeiten als vorteilhaft erwiesen hat. In einem solchen piezoelektrischen Aktor wird durch Anlegen einer elektrischen Spannung eine Längsänderung hervorgerufen, die auf das Servoventil übertragen wird, das dann wiederum die Einspritzdüse öffnet oder schließt.

Die extrem schnell schaltenden piezoelektrischen Aktoren mit Schaltzeiten im Bereich von unter 200 µs sind jedoch geeignet, hochfrequente mechanische Schwingungen anzuregen und in das den Piezoaktor umgebende Gehäuse einzuleiten. Diese Körperschallschwingungen pflanzen sich entlang des Injektorkörpers fort und werden in den Zylinderkopf der Brennkraftmaschine eingeleitet. Diese mechanischen Schwingungen auf der Oberfläche des Injektorkörpers und des Zylinderkopfes führen jedoch zu erheblichen Störgeräuschen, die den Fahrkomfort negativ beeinflussen.

Um die Geräuschemissionen von elektrisch betätigten Aktoren zu vermindern, werden diese herkömmlicherweise mit zusätzlichen Abdeckhauben versehen. Diese Schallisolierung durch Ummantelung ist jedoch aufwendig und teuer, da ein zusätzliches Bauteil hergestellt und montiert werden muss, das darüber hinaus einen großen Raumbedarf hat. Zudem sind derartige passive Schalldämpfungsmaßnahmen bei den beschriebenen Körperschallanregungen nur von äußerst begrenzter Wirksamkeit.

Ziel der Erfindung ist es, eine Aktoreinheit bereitzustellen, bei der auf kostengünstige und platzsparende Weise eine weitgehende Kompensation der Geräuschemission erreicht wird.

Dieses Ziel der Erfindung wird durch die Merkmale des unabhängigen Anspruchs erreicht. Ein Vorteil der Erfindung besteht darin, dass durch Segmentierung der einstückigen Kopfplatte einer Piezoantriebseinheit mit in die Kopfplatte abschnittsweise eingebrachtem Entkopplungsmaterial das Schallübertragungsverhalten optimiert werden kann. Auf diese Weise kann bereits die Anregung von störendem Körperschall an der Schallentstehungsquelle deutlich reduziert werden, was aufwendige und teuere passive Schalldämpfungsmaßnahmen überflüssig macht.

Diese Schalldämpfungsmaßnahmen sich nicht beschränkt auf den Einsatz bei piezoelektrischen Aktorelementen, sondern ebenso geeignet für andere schnell schaltende Antriebe, beispielsweise magnetostriktive Schaltelemente.

Weitere vorteilhafte Ausbildungen der Erfindung sind in den abhängigen Ansprüchen gekennzeichnet.

Die Erfindung wird anhand der Figuren 1 bis 2 näher erläutert. Es zeigen:
- Figur 1a: eine Teilschnittansicht eines Kopfbereiches einer piezoelektrischen Aktoreinheit in einer beispielheften, nicht erfindungsgemäßen Ausführungsform,
- Figur 1b: eine Schnittansicht A-A aus Figur 1a und
- Figur 2: eine Teilschnittansicht eines Kopfbereiches einer piezoelektrischen Aktoreinheit in einer erfindungsmäßen Ausführungsform.

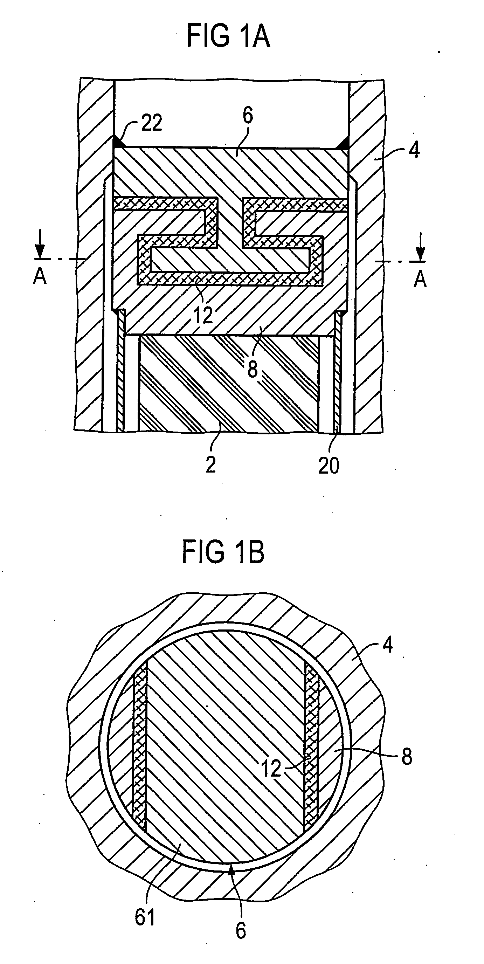

In der Figur 1a ist eine beispielheften, nicht erfindungsgemäßen Ausführungsform einer geräuschgedämpften piezoelektrischen Aktoreinheit, beispielsweise zur Ansteuerung eines hydraulischen Einspritzservoventils, dargestellt. Die Aktoreinheit besteht aus einer mehrteilig ausgeführten Kopfplatte 6, 8, einem auch als Piezostapel bzw. Piezostack bezeichneten Aktorelement 2, einer das Aktorelement 2 umhüllenden und nach außen abschließenden Rohrfeder 20 und einer Fußplatte, welche hier nicht dargestellt ist. Die Kopfplatte ist fest mit einem Gehäuse 4 verbunden, im dargestellten Ausführungsbeispiel über eine Schweissnaht 22.

Die Kopfplatte ist unterteilt in einen ersten Teil 6, einen zweiten Teil 8 und einer zwischen diesen Teilen angeordneten Zwischenschicht 12 aus Entkopplungsmaterial. Diese Teile 6, 8, 12 sind derart ineinander gefügt, dass in der seitlichen Schnittansicht entsprechend Figur 1a eine meanderförmige Struktur entsteht, und dass ein seitliches Ineinanderschieben der Einzelteile vor dem Einfügen in das Gehäuse 4 ermöglicht ist. Im zusammengebauten Zustand ist somit eine formschlüssige Verbindung der Teile 6, 8 und 12 gegeben.

Figur 1b zeigt eine Schnittansicht entlang der Schnittlinie A-A aus Figur la. Erkennbar ist die vom Gehäuse 4 umgebene kreisrunde Kopfplatte 6, 8, von der ein in der Seitenansicht entsprechend Figur 1a pilzförmig gestalteter unterer Abschnitt 61 des ersten Teils 6 als größere der Schnittflächen dargestellt ist. Das Entkopplungsmaterial 12 trennt diesen unteren Abschnitt 61 vom zweiten Teil 8, von dem hier nur zwei schmale äußere Streifen erkennbar sind.

Der zweite Teil 8 umgreift in der Seitenansicht entsprechend Figur 1a den unteren Abschnitt 61 des ersten Teils 6, so dass die beiden Teile 6, 8 in senkrechter Richtung zur Zeichnungsebene (Figur 1a) beziehungsweise parallel zu dieser (Figur 1b) ineinander geschoben werden können und zusammen mit dem sie trennenden Entkopplungsmaterial 12 die Kopfplatte bilden. Diese wird nach dem Zusammenbau mit dem Gehäuse 4 verschweißt, so dass eine feste Abstützung des Aktorelementes 2 zum Gehäuse 4 entsteht.

Als geeignete Materialen für das Entkopplungsmaterial kommen beispielsweise Metallschäume, die aus einer Paste aus Metallpartikeln und Bindemittel durch einen Sinterprozess hergestellt werden, in Frage. Dieser Metallschaum wird zweckmäßigerweise in den zwischen erstem Teil 6 und zweiten Teil 8 bestehenden Spalt eingepresst. Sinnvoll und vorteilhaft ist weiterhin die Verwendung von faserverstärkten Kunststoffmaterialien als Entkopplungsmaterial 12, wie z.B. Kohle- oder Glasfaserverstärktem Kunststoff. Auch Keramikschichten, welche üblicherweise durch einen Sinterprozess hergestellt werden, eignen sich als Entkopplungsmaterial. Durch eine solcherart inhomogene Struktur des Entkopplungsmaterials kann ein hohes Schalldissipationsvermögen erreicht werden, d.h. die Körperschallschwingungen werden in der Kopfplatte in Wärme umgewandelt und dadurch gedämpft, bevor sie nach außen abgestrahlt beziehungsweise in weitere Motorteile, wie den Zylinderkopf oder den Motorblock, eingeleitet und dort als Luftschall abgestrahlt werden können.

Weitere Variationsparameter dieser beispielheften Ausführungsform entsprechend der Figuren 1a und 1b sind die Dicke und die Anzahl der Schichten des Entkopplungsmaterials 12. So sind neben der gezeigten einzigen Schicht auch mehrere hintereinander angeordnete Schichten von Entkopplungsmaterial in der Kopfplatte möglich. Die Anzahl der Schichten wird dabei lediglich vom vorhandenen Einbauraum sowie vom beabsichtigten Bauaufwand begrenzt. Damit kann auch das Schallübertragungsverhalten bzw. die Steifigkeitseigenschaften der Kopfplatte beeinflusst und optimiert werden.

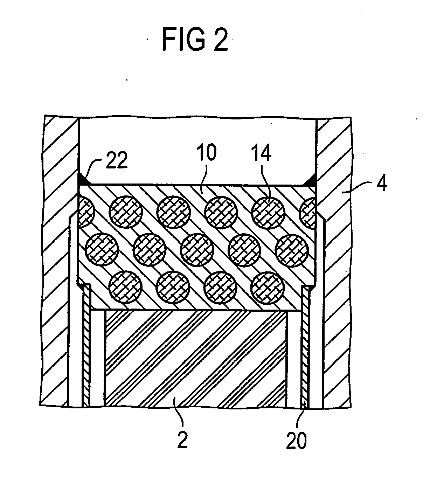

Die Figur 2 zeigt eine erfindungsgemäße Ausführungsform eines Kopfbereiches einer piezoelektrischen Aktoreinheit in einem seitlichen Teilschnitt. Gleiche Teile sind hierbei mit gleichen Bezugszeichen versehen. Die grundsätzliche Anordnung von Aktorelement 2, Gehäuse 4, Kopfplatte 10 und Rohrfeder 20 entspricht der ersten Ausführungsform entsprechend Figur 1. Allerdings ist die Kopfplatte 10 in dieser Ausführungsform einteilig ausgeführt und weist mehrere Zwischenräume 14 auf, die mit Entkopplungsmaterial vollständig ausgefüllt sind. Im dargestellten Ausführungsbeispiel sind die Zwischenräume 14 als kreisrunde Bohrungen ausgeführt. Möglich und sinnvoll können jedoch auch andere Konturen, beispielsweise elliptische oder mehreckige Durchbrüche sein.

Durch die solcherart entstehende inhomogene Struktur der Kopfplatte 10 wird auf wirkungsvolle Weise das Schallübertragungsverhalten positiv beeinflusst, indem die direkte Schallübertragung von der Schallquelle Aktorelement 2 (bzw. Piezostack) durch die Kopfplatte 10 über die Schweißnaht 22 in das Gehäuse 4 behindert und gedämpft wird. Eine gezielte Beeinflussung des Schallabsorptionsverhaltens ist durch die Wahl der Bohrungsdurchmesser sowie der verbleibenden Stegbreiten einerseits wie auch der Auswahl des optimalen Entkopplungsmaterials 12 andererseits möglich.

Auch an dieser Stelle soll nochmals erwähnt werden, dass sich die beschriebene Art der Entkopplung von schnellschaltenden Antrieben keineswegs auf piezoelektrische Aktoren beschränkt. Vielmehr lassen sich die beschriebenen Konstruktionselemente ebenso bei anderen Antriebselementen, beispielsweise bei magnetostriktiven Antriebselementen, sinnvoll einsetzen, um die Schallübertragungswege wirksam zu bedämpfen.

## Patentansprüche

1. Aktoreinheit mit einem Aktorelement (2) und einem das Aktorelement (2) umgebenden Aktorgehäuse (4), wobei ein oberer Endabschnitt des Aktorgehäuses mit dem Aktorelement verbunden ist, **dadurch gekennzeichnet, dass** zwischen dem Aktorelement (2) und dem Aktorgehäuse (4) eine mit dem Aktorgehäuse fest verbundene Kopfplatte (10) vorgesehen ist, die zumindest abschnittsweise eine inhomogene Materialstruktur aufweist, wobei sich in der einteilig ausgebildeten Kopfplatte (10) eine Vielzahl von Zwischenräumen (14) befinden, die mit Entkopplungsmaterial ausgefüllt sind.

2. Aktoreinheit nach Anspruch 1, **dadurch gekennzeichnet, dass** die Zwischenräume (14) als Bohrungen ausgebildet sind.

3. Aktoreinheit nach einem der vorstehenden Ansprüche, **dadurch gekennzeichnet, dass** das Aktorelement (2) ein piezoelektrisches Aktorelement ist.

4. Aktoreinheit nach einem der Ansprüche 1 oder 2, **dadurch gekennzeichnet, dass** das Aktorelement (2) ein magnetostriktives Aktorelement ist.

5. Aktoreinheit nach einem der vorstehenden Ansprüche, **dadurch gekennzeichnet, dass** der obere Endabschnitt des Aktorgehäuses (4) form- und/oder kraftschlüssig mit dem Aktorelement (2) verbunden ist.

6. Aktoreinheit nach einem der vorstehenden Ansprüche, **dadurch gekennzeichnet, dass** das Entkopplungsmaterial aus einem der folgenden Werkstoffe oder aus einer Kombination davon besteht:
- gesinterter Metallschaum, bestehend aus einer Mischung von Metallpartikeln und diese umgebenden Bindemittel;
- glasfaserverstärkter Kunststoff;
- kohlefaserverstärkter Kunststoff;
- gesinterter Keramik.

## Claims

1. Actuator unit comprising an actuator element (2) and an actuator housing (4) surrounding the actuator element (2), an upper end portion of the actuator housing being connected to the actuator element, **characterized in that** a head plate (10) which is fixedly connected to the actuator housing and has an inhomogeneous material structure, at least in certain portions, is provided between the actuator element (2) and the actuator housing (4), the head plate (10), which is formed as one part, containing a multitude of intermediate spaces (14) that are filled with isolating material.

2. Actuator unit according to Claim 1, **characterized in that** the intermediate spaces (14) are formed as bores.

3. Actuator unit according to one of the preceding claims, **characterized in that** the actuator element (2) is a piezoelectric actuator element.

4. Actuator unit according to either of claims 1 and 2, **characterized in that** the actuator element (2) is a magnetostrictive actuator element.

5. Actuator unit according to one of the preceding claims, **characterized in that** the upper end portion of the actuator housing (4) is positively and/or non-positively connected to the actuator element (2).

6. Actuator unit according to one of the preceding claims, **characterized in that** the isolating material consists of one of the following materials or a combination thereof;
- sintered metal foam, consisting of a mixture of metal particles and binder surrounding them;
- glass-fibre reinforced plastic;
- carbon-fibre reinforced plastic;
- sintered ceramic.

## Revendications

1. Unité d'actionnement, comprenant un actionneur (2) et un boîtier d'actionneur (4) entourant l'actionneur (2), dans laquelle une section finale supérieure du boîtier d'actionneur est reliée à l'actionneur, **caractérisée en ce que** entre l'actionneur (2) et le boîtier d'actionneur (4), on prévoit une plaque de tête (10) solidement reliée au boîtier d'actionneur, laquelle plaque présente au moins par sections une structure de matériau non homogène, une pluralité d'espaces intermédiaires (14), remplis d'un matériau de découplage, se trouvant dans la plaque de tête (10) réalisée d'un seul tenant.

2. Unité d'actionnement selon la revendication 1, **caractérisée en ce que** les espaces intermédiaires (14) se présentent sous la forme de perçages.

3. Unité d'actionnement selon l'une quelconque des revendications précédentes, **caractérisée en ce que** l'actionneur (2) est un actionneur piézoélectrique.

4. Unité d'actionnement selon l'une quelconque des revendications 1 ou 2, **caractérisée en ce que** l'actionneur (2) est un actionneur magnétostrictif.

5. Unité d'actionnement selon l'une quelconque des revendications précédentes, **caractérisée en ce que** la section finale supérieure du boîtier d'actionneur (4) est reliée par liaison de forme et/ou de force à l'actionneur (2).

6. Unité d'actionnement selon l'une quelconque des revendications précédentes, **caractérisée en ce que** le matériau de découplage est constitué de l'un des matériaux suivants ou de l'une de leurs combinaisons suivantes :
- mousse de métal fritté, constituée d'un mélange de particules métalliques et d'un liant entourant celles-ci ;
- matériau synthétique renforcé par des fibres de verre ;
- matériau synthétique renforcé par des fibres de carbone ; et
- céramique frittée.
